# DEMANDE DE BREVET EUROPEEN

(11) **EP 3 364 251 A1**
(43) Date de publication de la demande: **22.08.2018**
(21) Numéro de dépôt: 17156680.5
(22) Date de dépôt: 17.02.2017
(51) Int. Cl.: G03F 7/30

(54) **PROCEDE DE GRAVURE DE PLAQUES PHOTOPOLYMERES**

(71) Demandeur: GS Trading SA, 8279 Holzem (LU)
(72) Inventeur: CARDINI, Jean Louis, 92130 ISSY LES MOULINEAUX (FR); ADAMI, Nicolas, 57155 MARLY (FR)
(74) Mandataire: Hugues, Catherine

(57) **Abrégé**

La présente invention concerne un procédé de fabrication, à partir de plaques photopolymères, de clichés souples destinés à l'impression, dans lequel:
- On soumet les plaques photopolymères à une étape de polymérisation de zones aux rayonnements ultraviolets,
- On procède à une gravure des plaques photopolymères en les immergeant dans un bain de gravure et en les brossant,
- On effectue une filtration du bain de gravure.

Il est caractérisé en ce que pour effectuer l'étape de filtration, on utilise un dispositif de filtration comportant une surface poreuse dont une face est pourvue d'une pré-couche composée d'une ou plusieurs substance(s) de nature minérale et/ou de nature organique présentant des propriétés filtrantes et/ou adsorbantes et/ou absorbantes.

## Description

La présente invention a pour objet un procédé de fabrication, à partir de plaques photopolymères, de clichés souples, comportant des zones en relief, destinés à être utilisés dans l'industrie des arts graphiques pour effectuer des impressions, par exemple par flexographie, typographie ou offset sec, etc.

De manière classique, pour obtenir de tels clichés, il est d'usage d'exposer à un rayonnement ultraviolet des plaques photopolymères dont la face supérieure est recouverte d'un film négatif qui laisse apparentes les zones supposées s'étendre finalement en relief. Après durcissement des zones exposées par polymérisation, la face supérieure des plaques photopolymères est grattée à l'aide de brosses adaptées afin d'éliminer la matière des surfaces masquées et progressivement faire apparaître les zones en relief.

Cette gravure est couramment effectuée dans une machine dans laquelle un courant d'eau, porté à une température de l'ordre de 50°C, et additionné, le cas échéant, d'un système de lessive, circule en circuit fermé. Dès lors, des particules de polymère grattées se retrouvent en suspension dans la solution aqueuse utilisée, et s'y accumulent au fur et à mesure du grattage des plaques.

Il a été observé qu'au bout d'un certain nombre de plaques fabriquées (environ 10 à 20 en moyenne), la concentration des particules de polymères en suspension dans l'encourt d'eau devient inacceptable pour la qualité de la gravure, et impose le remplacement du bain de gravure saturé par un bain propre.

Cependant, ceci suppose, avec les technologies classiques actuelles, un arrêt complet de la machine à graver, afin de vidanger et nettoyer soigneusement l'ensemble de ses circuits, tuyauteries et divers composants.

De toute évidence, une telle contrainte entraîne une perte significative de la productivité, étant donné que selon la taille de la machine il faut compter entre une et deux heures de travail.

Par ailleurs, le mélange aqueux contenant les particules de polymères en suspension est néfaste pour l'environnement et ne peut faire l'objet d'un simple rejet dans le circuit domestique des eaux usées. Il suppose un traitement spécifique pour lequel les solutions proposées à ce jour ne donnent pas satisfaction.

Accessoirement, des phénomènes de gravure imparfaite des plaques polymères, dus à l'utilisation de bains de gravure excessivement chargés en particules, ont été observés, ce qui génère des coûts supplémentaires pour réaliser de nouvelles plaques dépourvues d'imperfections.

Il convient également de noter, qu'après grattage, les particules de polymères en suspension dans la solution aqueuse ont une granulométrie extrêmement fine, et présentent toutes une granulométrie inférieure à 100µm. En fonction du type de polymère dont est composée la plaque photopolymère, et de la technique de grattage employée, il a été constaté qu'en moyenne, 50% des particules présentent une granulométrie inférieure à 40/50µm, tandis que 10% ont une taille inférieure à 10µm et que 2% d'entre elles ont une taille inférieure à 2µm.

Il a par ailleurs été observé que les techniques de recyclage des bains de gravure connues à ce jour présentent des limites dues notamment au fait que la fraction des particules de taille inférieure à 10µm a un comportement de type colloïdal et va très rapidement colmater tout système de filtration employé. De plus, les particules de polymères en suspension ont une densité proche de 1 et un caractère de surface hydrophile ce qui rend non seulement tout système de sédimentation irréaliste, mais également toute technique de flottation par bulles d'air impossible.

Ainsi, bien que quelques solutions aient été proposées à ce jour pour recycler les solutions polymériques des bains de gravure, comme par exemple celles basées sur une filtration tangentielle par membranes céramiques, elles n'ont rencontré qu'un faible succès du fait d'une difficulté de mise en oeuvre et de résultats insatisfaisants. Par ailleurs, comme déjà précisé ci-dessus, les solutions proposées ne résolvent pas le problème du traitement du résidu final.

Par conséquent à ce jour, à la connaissance du demandeur, il n'existe pas de procédé industriellement répandu permettant un recyclage d'un bain de gravure qui, à la fois, est fiable, permet une élimination en continu des particules en suspension, ainsi que l'obtention d'un résidu final manipulable, non toxique pouvant suivre un circuit normal de collecte de déchets urbains et le renvoi dans les circuits existants d'une eau décontaminée ne contenant pratiquement plus de particules de polymères en suspension.

La présente invention a donc pour objectif de proposer une nouvelle solution permettant de pallier cette carence.

En d'autres termes, la présente invention entend proposer une solution industrialisable permettant d'assurer une élimination, de préférence en continu, des particules de polymères en suspension dans un bain de gravure, cette solution étant aisée à appliquer, peu coûteuse, et permettant de faire en sorte que les particules de polymères se retrouvent sous une forme inerte, sans danger pour la santé et l'environnement, et qui soit aisément manipulable et éliminable dans les circuits habituels de gestion des déchets.

A cet effet, l'invention a pour objet un procédé de fabrication, à partir de plaques photopolymères, de clichés souples destinés à l'impression, notamment par flexographie, typographie ou offset sec, dans lequel on effectue les étapes suivantes :
- On soumet les plaques photopolymères à une étape de polymérisation de zones par exposition à des rayonnements ultraviolets,
- On procède à une gravure des plaques photopolymères en les immergeant dans un bain de gravure et en les brossant afin d'éliminer la matière des zones non exposées,
- On effectue une filtration du bain de gravure pour éliminer les particules de polymères dont il se charge au fur et à mesure,
caractérisé en ce que pour effectuer l'étape de filtration, on utilise un dispositif de filtration préalablement préparé, comportant une surface poreuse dont une face est pourvue d'une pré-couche obtenue à partir d'une pulpe composée d'une ou plusieurs substance(s) de nature minérale et/ou de nature organique présentant des propriétés filtrantes et/ou adsorbantes et/ou absorbantes.

Conformément à un mode de réalisation préférentiel de l'invention, pour obtenir ladite pulpe, on utilise une/des substance(s) de nature minérale choisie(s) parmi la liste comprenant la perlite expansée, une zéolite, une diatomée et/ou une/des substance(s) de nature organique choisie(s) parmi la liste comprenant des fibres de cellulose, du charbon actif. Il convient de noter que selon le cas, ces composants peuvent tout à fait être utilisés seuls ou également en mélange.

L'invention prévoit également de procéder de manière telle que pour obtenir ladite pulpe, on place une ou plusieurs substance(s) de nature minérale et/ou de nature organique présentant des propriétés filtrantes et/ou adsorbantes et/ou absorbantes en suspension dans de l'eau à une concentration comprise entre 5% et 40% en masse, de préférence entre 10% et 20% en masse.

Par ailleurs, pour fabriquer ledit dispositif de filtration, il est prévu d'utiliser en tant que surface poreuse une grille filtrante présentant des ouvertures dont la taille est comprise entre 20µm et 120µm, de préférence entre 50µm et 100µm.

Conformément au procédé selon l'invention, pour obtenir ladite pré-couche, on dépose la pulpe sur une face de ladite surface poreuse et on évacue l'eau contenue dans la pulpe jusqu'à obtention, sur la face de la grille filtrante, d'une couche de pulpe d'une épaisseur comprise entre 3mm et 50mm, de préférence comprise entre 20mm et 40mm.

Afin d'accélérer cette étape, un vide partiel compris entre 0,2 Pa et 1,5 Pa, de préférence compris entre 0,5 Pa et 0,7 Pa peut être créé sous la surface poreuse.

Le procédé selon l'invention se caractérise encore en ce qu'après sa filtration, on réutilise le bain de gravure pour une nouvelle étape de gravure des plaques photopolymères, tandis que pendant ou après la filtration, on récupère sous forme de mélange solide les particules de polymères contenues dans le bain de gravure et on les évacue vers un réseau de traitement adapté.

Il est en outre possible d"effectuer l'étape de filtration du bain de gravure concomitamment à l'étape de gravure, ou en différé.

L'invention et ses avantages seront mieux compris à la lecture de la description qui suit, faite en référence à l'unique figure annexée illustrant un schéma de principe d'un procédé de gravure à l'eau de plaques photopolymères destinées à l'impression par flexographie.

Comme indiqué dans la partie introductive, le principe de la gravure de plaques photopolymères destinées à l'impression par flexographie consiste à gratter à l'aide de brosses adaptées la partie supérieure des plaques ayant subi un rayonnement ultraviolet.

Cette gravure est effectuée à l'aide d'une machine à graver 1, comportant classiquement un bac de gravure 2, et dans laquelle circule, en circuit fermé 3, un courant d'eau porté à une température de l'ordre de 50°C, et le cas échéant additionné d'un système de lessive.

Au fur et à mesure de la gravure des plaques photopolymères 4, les particules de polymères 5 grattées se retrouvent en suspension dans la solution aqueuse dont est rempli le bac de gravure 2 et s'y accumulent.

Sur le schéma de principe illustré, la machine à graver 1 comporte également un bac de séparation 6, relié par des moyens de raccordement fluidique au bac de gravure 2, et équipé d'un dispositif de filtration (non illustré) préalablement préparé, constitué d'une surface poreuse surmontée d'une pré-couche filtrante formée par un/des matériaux filtrants/adsorbants/absorbants, tels que définis ci-dessus.

Conformément au procédé selon l'invention, après avoir été prélevée, par des moyens de prélèvement classiques, sur le circuit 3 de circulation des eaux de la machine à graver 1, ou après avoir été pompée directement dans la cuve d'encours 2, l'eau chargée en particules 5 de polymères est ainsi injectée dans le bac de séparation 6, où elle va traverser le dispositif de filtration en le pénétrant au niveau de la pré-couche issue de ladite pulpe comprenant une ou plusieurs substance(s) de nature minérale et/ou de nature organique présentant des propriétés filtrantes et/ou adsorbantes et/ou absorbantes.

En fait, lorsque la quantité d'eau polluée injectée dans le bac de séparation 6 apparait suffisante, il suffit de la laisser percoler au travers du dispositif selon l'invention, c'est-à-dire au travers de la totalité de la couche minérale ou organique de la pré-couche puis de la surface poreuse qui supporte cette dernière.

Il a été constaté qu'après percolation, la solution aqueuse est suffisamment débarrassée des particules de polymères pour pouvoir être recyclée et réinjectée dans le circuit 3 de la machine à graver 1, pour de nouveaux cycles de gravure. Les particules de polymères forment alors, quant à elles, une croûte mince à la surface du dispositif de filtration selon l'invention, sur la pré-couche présentant des propriétés filtrantes, adsorbantes et/ou absorbantes qu'il comporte et au travers de laquelle la solution aqueuse polluée a percolé.

La croûte mince de particules de polymères ainsi obtenue et une fraction de la pré-couche filtrante et/ou adsorbante et/ou absorbante initiale ayant permis la percolation de la solution aqueuse peuvent alors être grattées de manière à récupérer un mélange solide 7 sous forme de poudre humide contenant les particules de polymères qui n'ont pas percolé. Ce mélange solide 7 peut alors être extrait de la cuve de séparation 6 et évacué via le circuit de gestion des déchets adéquat.

Par ailleurs, après grattage du mélange 7 sur le dispositif de filtration selon l'invention, ce dernier est au moins partiellement régénéré, de sorte qu'il est possible de répéter l'opération de percolation de la solution aqueuse, au moins jusqu'à ce qu'il ne reste, sur le dispositif de filtration selon l'invention, plus qu'une pré-couche présentant des propriétés filtrantes et/ou adsorbantes et/ou absorbantes résiduelle de quelques millimètres.

Il convient de noter que toutes ces opérations peuvent être réalisées « en continu » à l'aide d'une surface poreuse définie par un moyen de filtration classique tel que par exemple un filtre rotatif sous vide, un filtre à bande sous vide, un filtre à disques sous vide, un filtre presse à plateaux ou tout autre moyen de filtration équivalent.

Plusieurs essais ont été effectués afin de vérifier l'efficacité du dispositif de filtration que le présent procédé entend mettre en oeuvre dans le cadre du recyclage de bains de gravure de plaques photopolymères. Ces essais sont présentés ci-dessous :

### Essai A : Réalisé avec un filtre classique d'un premier type

Ce filtre d'un premier type consiste en une toile criblante en polyéthylene classique ayant des ouvertures dont la taille moyenne est de 40µm, installée sur un petit filtre rotatif de 400cm² de surface.

L'essai a été réalisé en utilisant une pompe à vide, permettant de créer un vide de l'ordre de 0,7 Pa, pour faciliter l'écoulement d'un liquide au travers de la toile criblante.

Lors de l'essai, une solution chargée en particules de polymères issue du grattage de plaques photopolymères et contenant 0,62% de particules de polymères en poids a alimenté, à l'aide d'une pompe, le petit filtre rotatif selon un débit contrôlé de 401/h.

Il a été constaté qu'au bout de 3 minutes, la toile criblante était complètement colmatée, de sorte qu'aucun liquide ne pouvait plus la traverser.

Par ailleurs, une augmentation jusqu'à 1 Pa du niveau de vide dans le filtre est demeurée sans effet.

Cet essai a permis de constater que les particules de polymères les plus fines, ayant un comportement de type colloïdal, se sont simplement collées sur les brins de la toile criblante dont elles ont entraîné très rapidement une absence totale de perméabilité, empêchant tout recyclage de la solution injectée de départ.

### Essai B : Réalisé avec un filtre de type classique d'un second type

Cet essai a été réalisé dans les mêmes conditions que l'essai A en remplaçant la toile criblante par une toile métallique en inox ayant des ouvertures dont la taille moyenne est de 80µm.

Le résultat a été identique à celui de l'essai A, le bouchage total de la toile métallique n'apparaissant cependant qu'au bout de 5 minutes.

### Essai 1 : réalisé avec un dispositif de filtration selon l'invention

Le dispositif de filtration selon l'invention utilisé dans cet essai a été préalablement préparé en plaçant une perlite expansée broyée, ayant une perméabilité de 5 Darcy, en suspension dans de l'eau avec une concentration de 10% en masse. Puis, la pulpe obtenue a été déposée sur la face supérieure d'un petit filtre à vide de laboratoire ayant une surface utile de 400cm² et possédant une lame pour gratter en continu la couche supérieure présentant des propriétés filtrante et/ou adsorbantes et/ou absorbantes obtenue à sa surface.

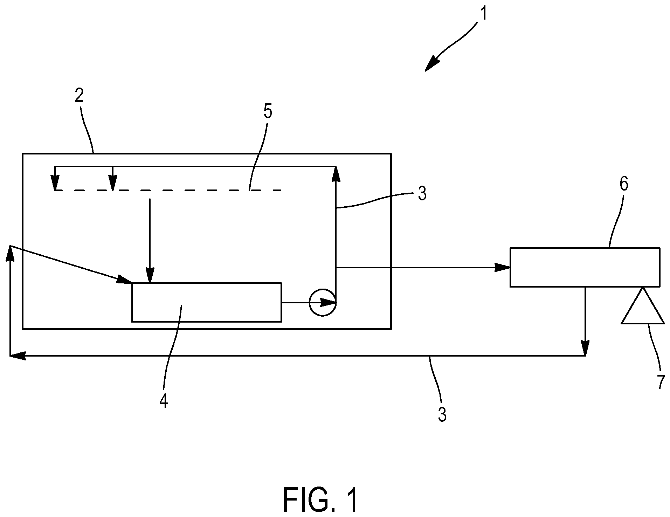

Le dispositif selon l'invention obtenu a été installé dans un bac de séparation 6 d'une machine à graver 1 telle qu'illustrée sur le schéma de principe de la figure 1.

50 litres d'eau contenant 0,62% en poids (soit 6,2 kg/m³) de particules de polymères issues du grattage d'une plaque photopolymère ont ensuite été injectés à travers le dispositif de filtration selon l'invention préalablement préparé. Un vide de 0,6 Pascal a été appliqué lors de la séparation.

Il a été constaté que, de manière surprenante, les fines particules de polymères (de taille inférieure à 10µm) sont retenues dans la couche présentant des propriétés filtrantes et/ou adsorbantes et/ou absorbantes du dispositif de filtration, quasiment dès les premiers millimètres de cette dernière.

Ces particules sont par conséquent éliminées en continu de la solution aqueuse, alors que les pores de ladite pré-couche filtrante/adsorbante/absorbante ont pour la plupart un diamètre supérieur à 10µm. Par ailleurs, la turbidité finale de la solution récupérée à la sortie est très faible, de sorte qu'une mesure de la concentration en % de particules de polymères résiduelles est impossible.

Les conditions et performances de cet essai sont indiquées dans le tableau ci-dessous :

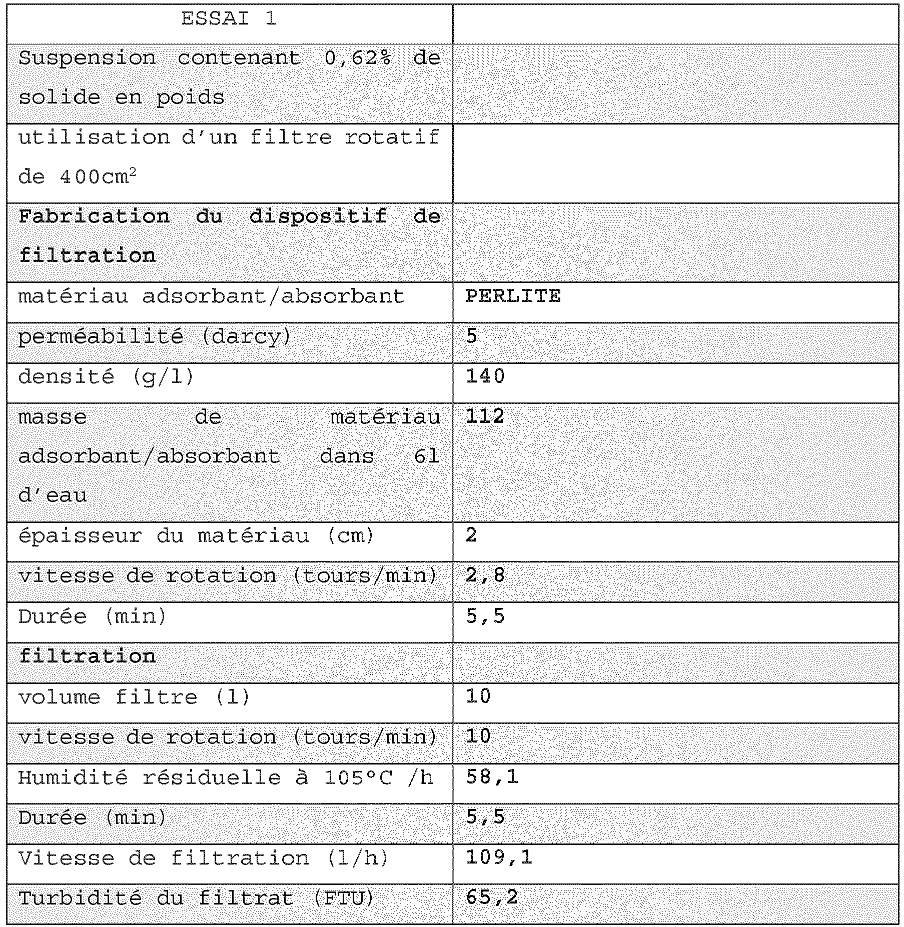

### Essai 2: réalisé avec un dispositif de filtration selon l'invention

Cet essai diffère de l'essai 1 par l'utilisation de diatomée à la place de la perlite expansée pour fabriquer le dispositif de filtration. Les autres conditions sont identiques.

Les conditions et performances de cet essai sont indiquées dans le tableau ci-dessous :

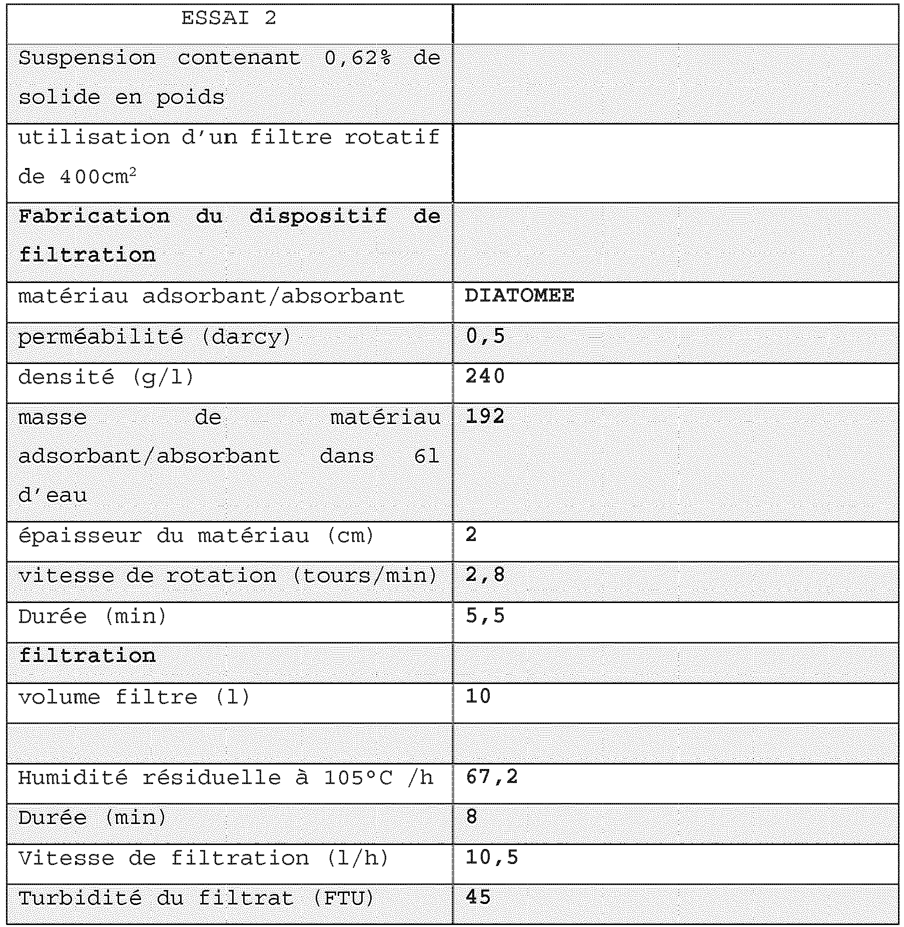

Par rapport à l'essai 1, on constate le même phénomène de rétention des particules fines. Cependant, le processus s'accompagne d'une chute du débit nominal tandis que la turbidité finale du filtrat est plus faible en raison d'une perméabilité de la diatomée plus faible que celle de la perlite.

### Essai 3 : réalisé avec un dispositif de filtration selon l'invention

Lors de cet essai, la solution aqueuse à filtrer était très chargée en particules de polymères, et contenait plus de 2% de solide, soit plus de 20kg de solide par m³ d'eau.

Le matériau utilisé pour fabriquer le dispositif de filtration selon l'invention était une perlite ayant une perméabilité de 3 Darcy. Un filtre rotatif sous vide de 400cm² a été employé et un vide de 0,7 Pa appliqué.

D'autres conditions et les performances de cet essai sont indiquées dans le tableau ci-dessous :

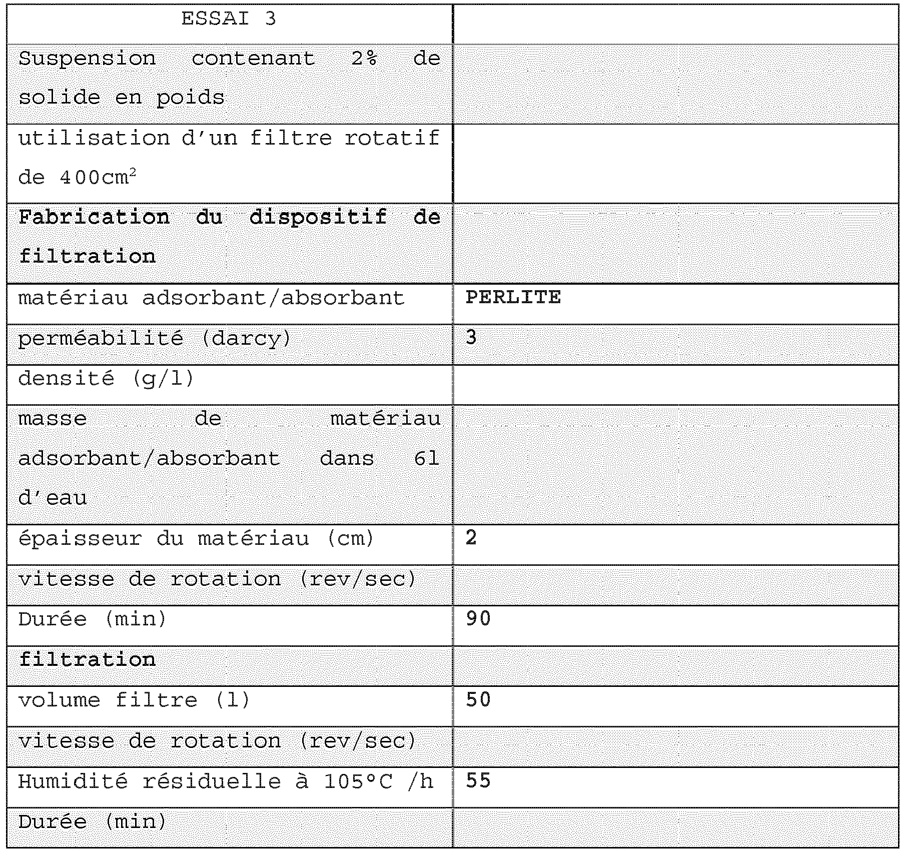

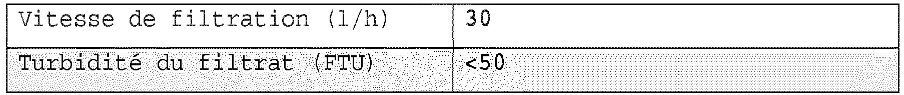

Les performances qui ressortent de ce tableau montrent que l'on satisfait les principales contraintes y compris en opérant sur une durée plus longue.

### Essai 4: réalisé avec un dispositif de filtration selon l'invention

Cet essai a consisté à tester les performances d'un dispositif de filtration conforme au procédé selon l'invention utilisé pendant une longue durée sur une solution de départ faiblement contaminée.

Les conditions et performances de cet essai sont indiquées dans le tableau ci-dessous :

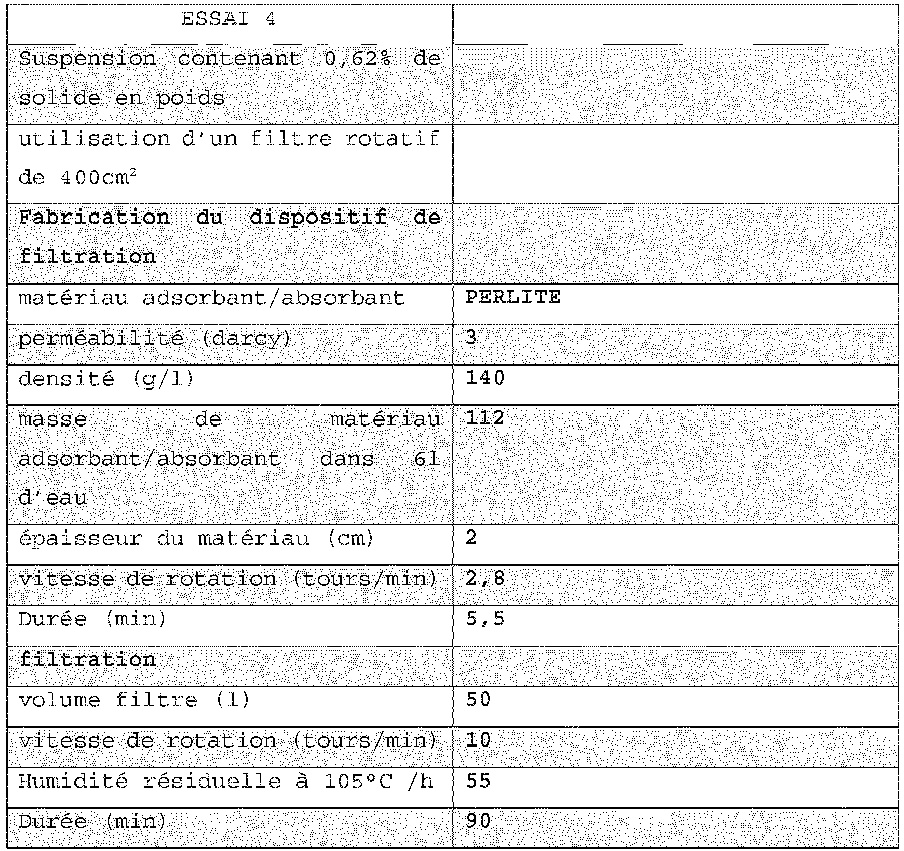

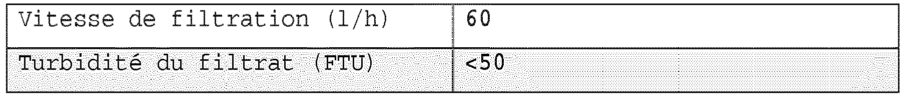

Il ressort de l'ensemble de ces essais que le dispositif de filtration que le procédé selon l'invention préconise d'utiliser est flexible et convient pour de nombreux types de solutions aqueuses de départ.

Par ailleurs, l'ensemble des essais réalisés permet également de constater que l'invention permet bien d'atteindre les objectifs préalablement énoncés et fournit une solution pouvant être utilisée de manière industrielle pour recycler facilement, avec un coût réduit, une solution polymérique par exemple d'un bain de gravure de plaques photopolymères. De plus, le rejet solide obtenu peut facilement être récupéré et évacué vers un centre de traitement de déchets adapté, tandis que la solution recyclée peut être réutilisée, par exemple pour de nouveaux cycles de gravure de plaques photopolymères.

## Revendications

1. Procédé de fabrication, à partir de plaques photopolymères, de clichés souples destinés à l'impression, notamment par flexographie, typographie ou offset sec, dans lequel on effectue les étapes suivantes :
- On soumet les plaques photopolymères à une étape de polymérisation de zones par exposition à des rayonnements ultraviolets,
- On procède à une gravure des plaques photopolymères en les immergeant dans un bain de gravure et en les brossant afin d'éliminer la matière des zones non exposées,
- On effectue une filtration du bain de gravure pour éliminer les particules de polymères dont il se charge au fur et à mesure,
**caractérisé en ce que** pour effectuer l'étape de filtration, on utilise un dispositif de filtration préalablement préparé, comportant une surface poreuse dont une face est pourvue d'une pré-couche obtenue à partir d'une pulpe composée d'une ou plusieurs substance(s) de nature minérale et/ou de nature organique présentant des propriétés filtrantes et/ou adsorbantes et/ou absorbantes.

2. Procédé selon la revendication 1, **caractérisé en ce que** pour obtenir ladite pulpe, on utilise une/des substance(s) de nature minérale choisie(s) parmi la liste comprenant la perlite expansée, une zéolite, une diatomée et/ou une/des substance(s) de nature organique choisie(s) parmi la liste comprenant des fibres de cellulose, du charbon actif.

3. Procédé selon l'une quelconque des revendications 1 ou 2, **caractérisé en ce que** pour obtenir ladite pulpe, on place une ou plusieurs substance(s) de nature minérale et/ou de nature organique présentant des propriétés filtrantes et/ou adsorbantes et/ou absorbantes en suspension dans de l'eau à une concentration comprise entre 5% et 40% en masse, de préférence entre 10% et 20% en masse.

4. Procédé selon l'une quelconque des revendications précédentes, **caractérisé en ce que**, pour fabriquer ledit dispositif de filtration, on utilise en tant que surface poreuse une grille filtrante présentant des ouvertures dont la taille est comprise entre 20µm et 120µm, de préférence entre 50µm et 100µm.

5. Procédé selon l'une quelconque des revendications 3 ou 4, **caractérisé en ce que** pour obtenir ladite pré-couche, on dépose ladite pulpe sur une face de ladite surface poreuse et on évacue l'eau contenue dans la pulpe jusqu'à obtention, sur la face de la surface poreuse, d'une couche de pulpe d'une épaisseur comprise entre 3mm et 50mm, de préférence comprise entre 20mm et 40mm.

6. Procédé selon la revendication précédente, **caractérisé en ce que** pour évacuer l'eau contenue dans la pulpe déposée sur la face de la surface poreuse, on crée sous cette dernière un vide partiel compris entre 0,2 Pa et 1,5 Pa, de préférence compris entre 0,5 Pa et 0,7 Pa.

7. Procédé selon l'une quelconque des revendications précédentes, **caractérisé en ce qu'**après sa filtration, on réutilise le bain de gravure pour une nouvelle étape de gravure des plaques photopolymères.

8. Procédé selon l'une quelconque des revendications précédentes, **caractérisé en ce que** pendant ou après la filtration, on récupère sous forme de mélange solide les particules de polymères contenues dans le bain de gravure et on les évacue vers un réseau de traitement adapté.

9. Procédé selon l'une quelconque des revendications précédentes, **caractérisé en ce que** l'on effectue l'étape de filtration du bain de gravure concomitamment à l'étape de gravure ou en différé par rapport à celle-ci.
